# EUROPEAN PATENT APPLICATION

(11) **EP 0 854 374 A2**
(43) Date of publication of application: **22.07.1998**
(21) Application number: 98300290.8
(22) Date of filing: 16.01.1998
(51) Int. Cl.: G02B 27/28, G02B 17/00, G03F 7/20

(54) **Illumination apparatus with a high laser damage threshold and pattern transfer apparatus comprising the same**

(30) Priority: 17.01.1997 JP 6291/97
(71) Applicant: NIKON CORPORATION, Tokyo 100 (JP)
(72) Inventor: Tanitsu, Osamu, c/o Nikon Corporation,, Tokyo 100 (JP); Oshikawa, Satoru, c/o Nikon Corporation,, Tokyo 100 (JP)
(74) Representative: Meddle, Alan Leonard

(57) **Abstract**

Illumination apparatus are disclosed for directing a laser beam or other light flux onto a target. The apparatus controls the polarization direction of the laser beam or other light flux with retarders in order to increase the damage resistance of the reflective coatings of the illumination apparatus. In addition, methods are disclosed for improving the damage resistance of reflective coatings used on optical elements of, e.g., a pattern transfer apparatus for projecting patterns from a reticle onto a substrate.

## Description

### Field of the Invention

The invention pertains to an illumination apparatus having an increased damage resistance to high-intensity laser beams.

### Background of the Invention

High-power laser beams tend to damage coatings used in high-reflectivity mirrors. The high-power beams from excimer lasers are especially likely to damage mirror coatings because such beams are at ultraviolet wavelengths that are close to the absorption edges of many coating materials. Therefore, coatings used with excimer lasers are frequently damaged or exhibit rapid degradation.

In order to improve the damage resistance of reflective coatings, improvements have been made in coating materials and coating processes. These improvements include the use of coating materials with low absorption, coating deposition methods that maintain the low absorption of the coating material, and providing additional protective coating layers. However, even with these improvements, further improvements are required for damage-free, long-term operation of such coatings.

### Summary of the Invention

According to the present invention, in order to improve the damage resistance of optical coatings to high-intensity illumination, including illumination at short wavelengths such as the excimer laser wavelengths of 193 nm and 248 nm, the polarization direction of an incident laser beam or other light flux is oriented to be at least partially P-polarized with respect to the coating.

An illumination apparatus according to a first representative embodiment of the invention comprises a first mirror, a first retarder, and a second mirror. The first mirror receives a laser beam or other polarized light flux that is partially P-polarized with respect to the mirror. The first mirror directs the laser beam to the first retarder and the second mirror. The first retarder alters the polarization directionof the laser beam reflected by the first mirror so that the laser beam is partially P-polarized with respect to the second mirror.

Each of the first and second mirrors comprises a substrate and a coating. The coating comprises alternating high-index and low-index layers. The high-index layers contain at least one material from the group consisting of HfO₂, Al₂O₃, LaF₃, and NdF₃. The low-index layers contain at least one material from the group consisting of SiO₂, MgF₂, AlF₃, and NdAlF₆.

The laser beam is preferably substantially P-polarized with respect to the first and second mirrors. If the laser beam is substantially P-polarized with respect to the first mirror, then the first retarder is preferably a half-wave retarder.

In this embodiment of the invention, the fluence of the laser beam is at least 100 mJ/cm² or has a peak intensity of at least 10⁷ W/cm².

The illumination apparatus of this embodiment can further comprise a second retarder that receives the laser beam before the laser beam is reflected by the first mirror. The second retarder changes the polarization of the laser beam so that the beam is partially or substantially P-polarized with respect to the first mirror. In this embodiment, the laser beam can thus be S-polarized when the laser beam reaches the second retarder.

An illumination apparatus according to a second representative embodiment of the invention comprises a first mirror that receives and reflects a partially P-polarized light flux. The apparatus further comprises a second mirror that receives the light flux from the first mirror and reflects the light flux in a plane that is tilted with respect to the plane of incidence of the first mirror. (The plane of incidence of the mirror is defined in the customary way, wherein the plane of incidence contains the propagation direction of the light flux to the mirror and a line perpendicular to the mirror.) The apparatus further comprises a first retarder placed between the first and second mirrors. The first retarder changes the polarization of the light flux received from the first mirror so that the light flux is at least partially P-polarized with respect to the second mirror.

If the light flux incident to the first and second mirrors is substantially P-polarized with respect to the mirrors, then the first retarder is preferably a half-wave retarder.

A second retarder can be provided so that the light flux is transmitted by the second retarder before reaching the first mirror. The light flux incident to the second retarder can be S-polarized with respect to the first mirror and the second retarder changes the polarization so that the laser beam is partially P-polarized with respect to the first mirror.

An illumination apparatus according to the invention can comprise a laser that emits a polarized laser beam, a plurality of mirrors, and a corresponding plurality of retarders. In such a configuration, the retarders are placed so that the laser beam is partially P-polarized, preferably substantially P-polarized, with respect to the mirrors. To provide a uniform light flux, an optical integrator is provided that receives the laser beam from the plurality of mirrors.

According to yet another embodiment of the invention, a pattern transfer apparatus is provided for projecting patterns from a reticle or mask onto a sensitized substrate. The apparatus comprises a reticle stage and a substrate stage for holding the reticle and substrate, respectively, and a light source that produces a polarized light flux. The light flux is directed to the reticle by a plurality of mirrors and a plurality of retarders that are arranged so that the light flux is at least partially P-polarized with respect to each of the mirrors. The light flux is preferably substantially P-pclarized with respect to each of the mirrors.

According to another aspect of the invention, methods are provided for decreasing the rate at which a mirror is damaged by a light flux. A representative method comprises providing a retarder and orienting the polarization of the light flux to be partially P-polarized with respect to the mirror.

The foregoing and other features and advantages of the invention will become more apparent from the following detailed description of example embodiments which proceeds with reference to the accompanying drawings.

### Brief Description of Drawings

FIG. 1 is a sectional view of a mirror made of multiple dielectric layers deposited on a substrate.

FIG. 2 is a graph of the reflectivity of the mirror of FIG. 1 as a function of wavelength.

FIG. 3 is a graph of relative intensity as a function of penetration depth into the coating of FIG. 1 for an incident S-polarized light flux.

FIG. 4 is a graph of relative intensity as a function of penetration depth into the coating of FIG. 1 for an incident P-polarized light flux.

FIG. 5 is a graph of the damage threshold of the coating of FIG. 1 as a function of the number of pulses received by the coating.

FIG. 6A-6B are perspective views of an illumination apparatus according to Example Embodiment 1.

FIG. 7A-7B are perspective views of an illumination apparatus according to Example Embodiment 2.

FIG. 8 is a perspective view of a pattern transfer apparatus according to Example Embodiment 3.

### Detailed Description

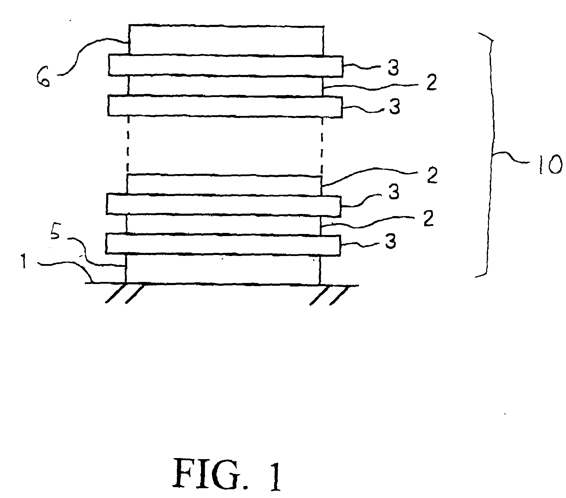

With reference to FIG. 1, a reflective coating 10 for use with a KrF excimer laser beam of wavelength λ = 248 nm comprises an alternating series of high-index layers 3 and low-index layers 2 deposited on a substrate 1. While many suitable high-index and low-index coating materials are known, the high-index layers 3 are preferably made of Al₂O₃ and the low-index layers 2 are preferably made of SiO₂. In addition, the coating 10 preferably comprises an undercoat 5 and an overcoat 6 for improved damage resistance. The thicknesses of the layers 2, 3 are selected so that the coating 10 has maximum reflectivity for light of wavelength λ = 248 nm and having an angle of incidence of 45°. It will be obvious to those skilled in the art that the thicknesses of the layers 2, 3 can be adjusted for other angles of incidence.

The reflectivity of a surface generally depends upon the polarization direction of the incident light flux. Following the usual convention, the plane of incidence for a light flux incident to a surface is defined as a plane containing a line perpendicular to the surface and the propagation direction of the light flux to the surface. A light flux polarized with an electric field vector parallel to the plane of incidence is P-polarized; a light flux polarized with an electric field vector perpendicular to the plane of incidence is S-polarized.

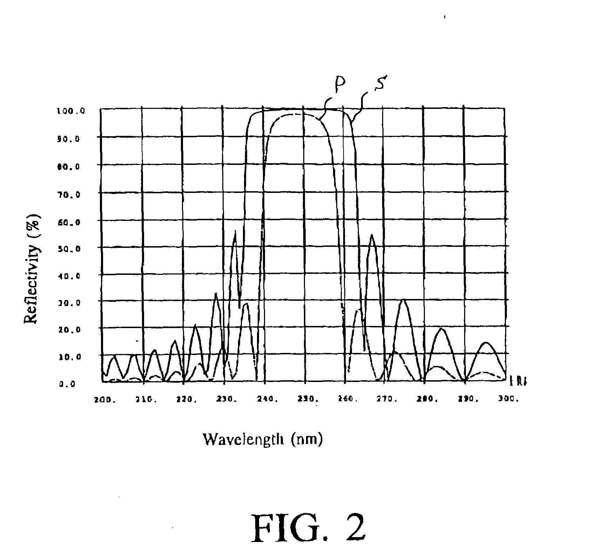

With reference to the graph of FIG. 2, it is apparent that the reflectivity of the coating 10 is larger over a broader wavelength band for an incident S-polarized light flux than for a P-polarized light flux. For this reason, conventional apparatus are arranged so that S-polarized light fluxes such as laser beams are incident to the coating 10.

The inventors of the present invention have observed that the damage resistance of the coating 10 depends on the magnitude of the electric field produced within the coating 10 by an incident light flux. Furthermore, the inventors have investigated the damage resistance of coatings such as the coating 10 as a function of polarization direction.

For convenience in describing the example embodiments of the present invention, the relative intensity of a light flux is defined as the square of the magnitude of the electric field. If |E| represents the magnitude of the electric field, then the relative intensity is |E|². As used herein, intensity has the customary meaning of laser power per area and can be expressed in W/cm².

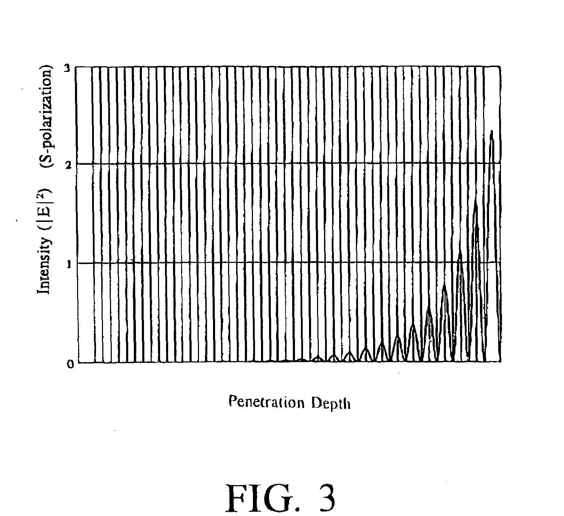

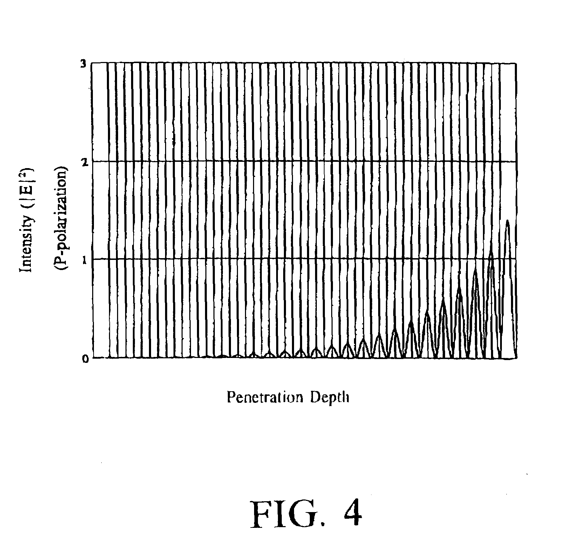

FIGS. 3-4 are graphs of the relative intensities (|E|²) within the coating 10 as a function of penetration depth into the coating for S- and P-polarized light fluxes of equal incident relative intensities, respectively. It is apparent from FIGS. 3-4 that the magnitude of the electric field |E| inside the coating 10 is larger for S-polarized light than for P-polarized light.

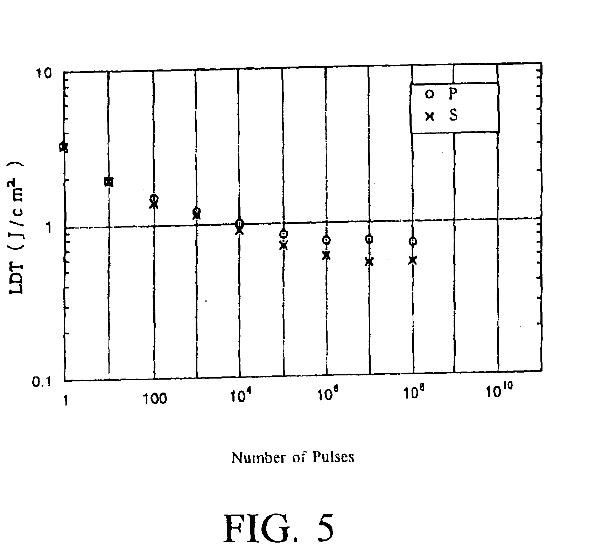

The higher electric field produced by an incident S-polarized light flux has been experimentally demonstrated to increase the rate at which the coating 10 is damaged. A pulsed excimer laser was arranged to irradiate the coating 10 with a series of S-polarized or P-polarized laser pulses. The laser produced a 248 nm or 193 nm laser beam that consisted of a series of laser pulses of pulse width of about 10 nsec at a repetition rate of 10 kHz. The fluence (energy/area per pulse in mJ/cm²) supplied by the pulses was varied and the number of pulses to which the coating 10 was exposed before the coating was damaged was recorded. A laser damage threshold (LDT) is defined as the fluence (in J/cm²) that damages the coating 10. (The LDT depends also on the peak intensity, pulse duration, and repetition rate of the laser pulses, wherein peak intensity is approximately the fluence divided by the pulse duration.) With reference to FIG. 5, the LDT is graphed as a function of the number of S- and P-polarized pulses required to damage the coating 10. It is apparent from FIG. 5 that the LDT is larger for P-polarized pulses than for S-polarized pulses.

Conventional optical systems used to deliver excimer laser beams are arranged so that reflective coatings receive an S-polarized light flux. As shown in FIG. 2 and discussed above, such an arrangement reduces the optical power loss at the coatings and provides a larger optical bandwidth than would be obtained with P-polarization. However, as demonstrated in FIG. 5, such an arrangement is undesirable with respect to the LDT for which the P-polarization direction is superior. Consequently, the damage resistance and the lifetime of coatings can be extended by arranging the coatings and incident fluxes so that the incident fluxes are P-polarized with respect to the coatings.

While the incident flux is preferably completely P-polarized, any state of polarization with a reduced S-polarization component tends to extend coating lifetime. For example, elliptical polarizations (including circular polarization) have a reduced S-polarization component in comparison with an S-polarized flux.

For convenience in describing the example embodiments, a light flux (such as a laser beam) is said to be "substantially polarized" along an axis if at least 90% of the optical power of the light flux would be transmitted by a perfect polarizer oriented to transmit linear polarization along that axis. A light flux is said to be "significantly polarized" along an axis if at least 10% of the optical power of the light flux would be transmitted by a perfect polarizer oriented to along that axis. A light flux is said to be at least partially polarized along an axis if at least some portion of the optical power of the light flux would be transmitted by a perfect polarizer oriented along that axis.

It will be apparent that a light flux can be substantially or partially S-polarized if the flux is substantially or partially polarized along an axis perpendicular to the plane of incidence of the light flux to a surface. A light flux is substantially or partially P-polarized if the flux if substantially or partially polarized along an axis parallel to the plane of incidence of the light flux to a surface.

Using these definitions, it will be apparent that a light flux having an elliptical polarization is partially P-polarized and S-polarized. Similarly, a light flux having a linear polarization that is not parallel or perpendicular to a plane of incidence is partially P-polarized and S-polarized. Depending on the orientation of these elliptical or linear polarizations, such fluxes can also be substantially P-polarized or S-polarized.

For convenience in describing the example embodiments, a plane containing a direction of propagation of a laser beam or other light flux is said to be "substantially tilted" with respect to another plane if the angle between the direction of propagation and the plane is greater than 75°; if the angle is greater than 10°, then the plane is said to be "significantly tilted."

### Example Embodiment 1

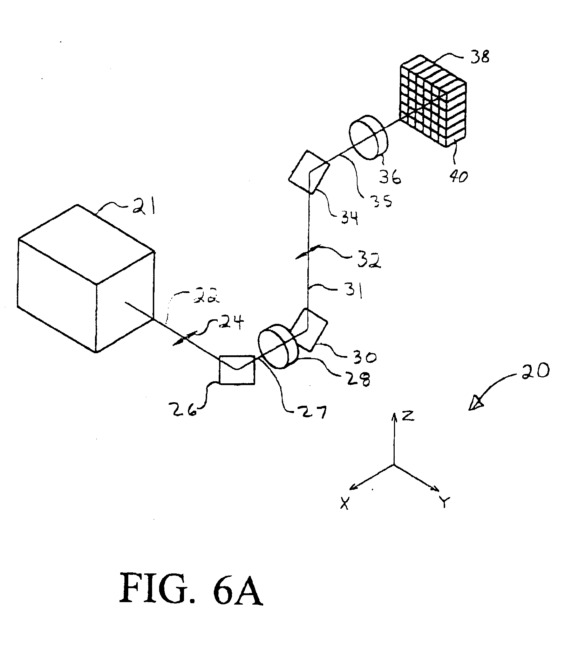

With reference to FIGS. 6A-6B, an XYZ coordinate system 20 having mutually orthogonal X, Y, and Z axes is used to describe Example Embodiment 1. With reference to FIG. 6A, an illumination apparatus comprises a KrF or an ArF excimer laser 21 that emits a laser beam, typically a series of laser pulses, at a wavelength of 248 nm or 193 nm, respectively, along an axis 22. The beam is substantially polarized along a direction 24 that is parallel to the X-axis. The pulse duration of the pulses from the KrF laser is 10 nsec and the pulses are emitted at a rate of 10 kHz. It will be apparent that other lasers have different pulse durations and repetition rates and that the invention is not limited to particular pulse durations or repetitions rates.

The beam propagates in the +Y-direction along the axis 22 to a mirror 26. The mirror 26 is oriented so that the beam is substantially P-polarized with respect to the mirror 26. The mirror 26 reflects the beam in the -X-direction along an axis 27 through a half-wave retarder 28 to a mirror 30. The mirror 30 reflects the beam so that it propagates in the +Z-direction.

The beam incident to the half-wave retarder 28 is substantially polarized perpendicular to the Z-axis; the half-wave retarder 28 rotates the polarization direction so that the beam exiting the half-wave retarder 28 is substantially polarized parallel to the Z-axis. After reflection by the mirror 30, the laser beam is substantially polarized in a direction 32, parallel to the X-axis, i.e., the laser beam is substantially P-polarized with respect to each of the mirrors 30, 34.

Without rotation of the polarization direction by the half-wave retarder 28, the beam would be substantially S-polarized with respect to the mirror 30. The half-wave retarder 28 is located to rotate the polarization direction before the beam reaches the mirror 30.

In Example Embodiment 1, the mirror 30 is arranged to reflect the beam so that the beam propagates parallel to the Z-axis. Other arrangements of the mirror 30 and the half-wave retarder 28 are possible. Orientations of the mirror 30 in which the laser beam is reflected so that it propagates in a plane that is tilted with respect to the plane of incidence of the mirror 26 require re-orientation of the polarization direction of the laser beam with a retarder such as the half-wave retarder 28. The reflected laser beam can propagate-in plane that is significantly or substantially tilted with respect to the plane of incidence of the mirror 26. If the tilt is significant or substantial, then correspondingly large re-orientations of the polarization of the light flux are beneficial.

There are various types of retarders suitable for the half-wave retarder 28. A retarder generally has fast and slow axes; light polarized along the fast axis has a higher propagation speed than light polarized along the slow axis. The polarization components of an incident light flux along the fast and slow axes of a retarder are phase-shifted with respect to each other. By adjusting the magnitude of the phase shift to be equivalent to one-half wavelength, a half-wave retarder is produced.

One type of retarder is a multiple-order retarder. A multiple-order half-wave retarder produces a phase difference (retardance) of nλ + λ/2 between the polarization components of an incident light flux, where n is an integer and λ is the wavelength of the light flux. The retardance of a multiple-order retarder varies as a function of the wavelength λ and the angle of incidence of the incident light flux. These variations are small for thin, multiple-order retarders, i.e., if n is small.

Zero-order retarders are superior to multiple-order retarders because retardance variations caused by variations in wavelength and angle of incidence are reduced. A zero-order retarder produces a phase difference of λ/2 between incident polarizations. A zero-order retarder can be made from a thin section of a birefringent material such as crystalline quartz. Alternatively, a zero-order retarder can be made by combining two thick sections of a birefringent material so that the fast and slow axes of the sections are perpendicular. The sections can be joined by polishing each section flat and then optically contacting the sections.

After reflection by the mirror 30, the laser beam propagates in the +Z-direction to the mirror 34. The mirror 34 reflects the laser beam so that the laser beam propagates in the -X-direction. Because the laser beam incident to the mirror 34 is polarized substantially parallel to the X-axis, the laser beam is substantially P-polarized with respect to the mirror 34.

The laser beam reflected by the mirror 34 propagates along an axis 35 to a beam expander 36; the beam expander 36 is an afocal optical system and can be a cylindrical optical system. The beam expander 36 can change the cross-sectional shape of the laser beam or change the diameter of the laser beam. After shaping by the beam expander 36, the laser beam is incident to a fly-eye lens 38 that contains multiple lens elements 40. The fly-eye lens 38 forms multiple images of the laser beam, creating a more uniform light flux.

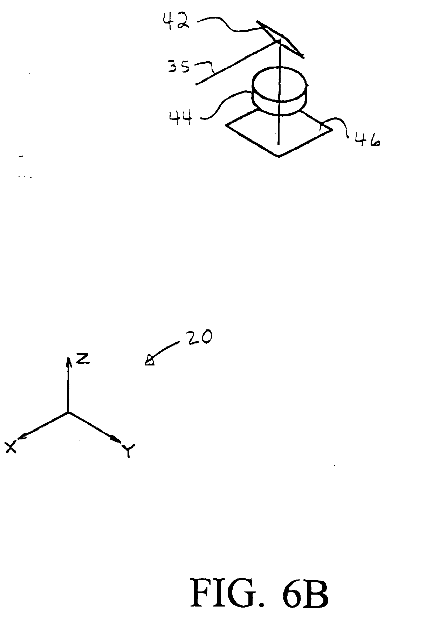

With reference to FIG. 6B, the light flux produced by the fly-eye lens 38 propagates along the axis 35 to a mirror 42 and a condenser lens system 44. The condenser lens 44 directs the light flux onto a target 46. Because the light flux produced by the fly-eye lens 38 has a lower intensity than the laser beam, the mirror 42 is much less likely to be damaged than the mirrors 26, 30, 34. The damage resistance of the mirrors 26, 30, 34 is improved because they receive P-polarized light but re-orientation of the polarization is not necessary at the mirror 42.

The mirrors 26, 30, 34 have reflective coatings made of layers of Al₂O₃ and SiO₂. The thicknesses of the layers are preferably selected to maximize reflectivity for light incident at 45°. The mirrors 26, 30, 34 also preferably have overcoating and undercoating layers to improve coating damage resistance. It will be apparent that these mirror coatings can be made of other materials. For example, the high-index layers can be made of materials such as HfO₂, Al₂O₃, LaF₃, and NdF₃; the low-index layers can be made of materials such as SiO₂, MgF₂, AlF₃, and NdAlF₆.

### Example Embodiment 2

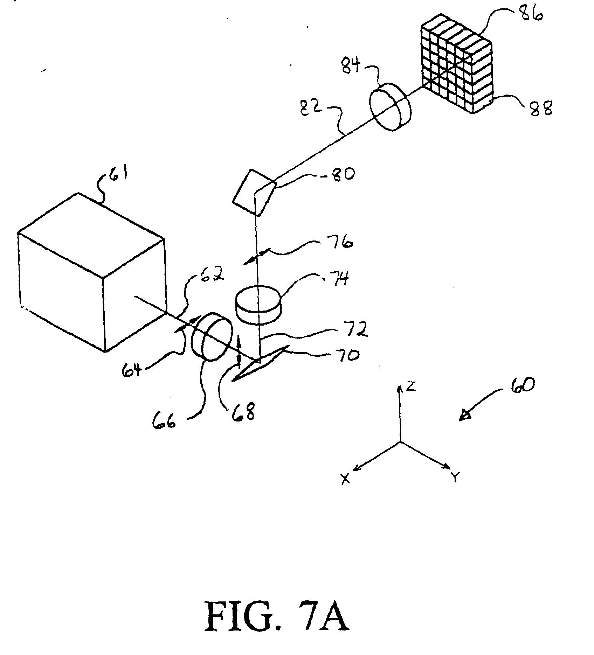

An illumination apparatus according to Example Embodiment 2 is described with reference to FIGS. 7A-7B. An XYZ coordinate system 60 is used in FIGS. 7A-7B. With reference to FIG. 7A, an illumination apparatus comprises an excimer laser 61 that emits a laser beam, typically a series of laser pulses, along an axis 62. The laser beam is substantially polarized in a direction 64 parallel to the X-axis. The laser beam propagates along the axis 62 in the +Y-direction to a half-wave retarder 66 and then to a mirror 70. The half-wave retarder 66 is oriented to rotate the plane of polarization of the laser beam so that the beam is substantially P-polarized with respect to the mirror 70; without the retarder 66, the laser beam would be substantially S-polarized with respect to the mirror 70.

The mirror 70 reflects the laser beam along an axis 72 to a half-wave retarder 74 and a mirror 80. The half-wave retarder 74 is oriented to rotate the plane of polarization of the laser beam so that the beam is substantially P-polarized with respect to the mirror 80, i.e, the laser beam is polarized substantially parallel to the X-axis. Without the retarder 74, the laser beam would be substantially S-polarized with respect to the mirror 80. The half-wave retarder 74 is oriented so that its optical axis is inclined at 45° to the polarization plane of the laser beam.

The mirror 80 reflects the laser beam along an axis 82 in the -x-direction to a beam expander 84; the beam expander can be an afocal system and can comprise cylindrical optics for shaping the laser beam. The laser beam exits the beam expander 84 and propagates to a fly-eye lens 86 that comprises an array of lens elements 88. The fly-eye lens 86 forms multiple beams from the laser beam, creating a more uniform light flux.

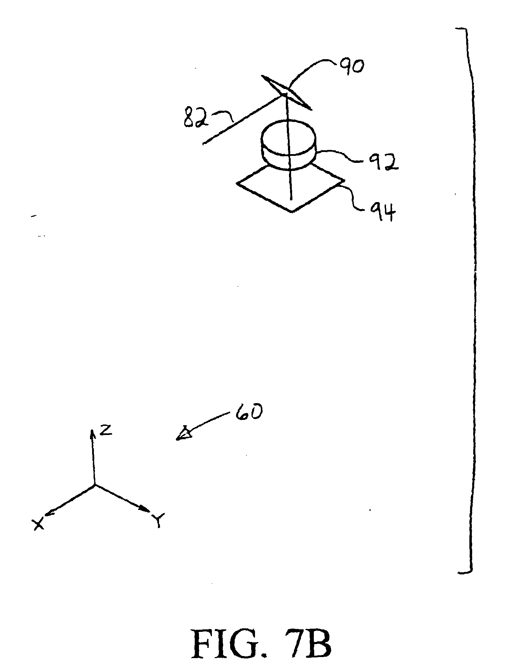

With reference to FIG. 7B, the light flux from the fly-eye lens 86 is reflected by a folding mirror 90 to a condenser lens system 92 and then illuminates a target 94.

In Example Embodiment 2, the damage resistance of the mirrors 70, 80 is improved because these mirrors receive substantially P-polarized laser beams. Furthermore, because the half-wave retarder 74 is located between the mirrors 70, 80, the laser beam incident to the mirror 80 can be substantially P-polarized even if the laser beam would be substantially S-polarized without the retarder 74.

Additional optical elements can be provided in the illumination apparatus of FIGS. 7A-7B. For example, a partially reflecting mirror can be inserted between the mirrors 70, 80 to select a small portion of the laser beam for monitoring the laser beam. The polarization at the partially reflecting mirror can be selected with a retarder, such as a 1/n-wave retarder, where n is an integer.

In Example Embodiments 1 and 2, the laser beam is substantially P-polarized with respect to the mirrors 70, 80. It will be apparent that the polarization of the laser beam can be arranged to be partially P-polarized to increase the damage resistance of the mirror coatings. For example, the polarization of the laser beam can be elliptical with respect to the mirrors 70, 80. If the laser beam emitted by the laser 61 is linearly polarized, quarter-wave retarders or other 1/n-wave retarders can be used to produce elliptical or circular polarizations that are partially P-polarized with respect to the mirrors 70, 80.

The illumination apparatus of Example Embodiments 1 and 2 can comprise additional optical elements for shaping or expanding the cross-section of the light flux or the laser beam. The intensity at the various mirrors then differs; in this case, circularly polarized or elliptically polarized light can be satisfactory at mirrors at which the light flux or laser beam has a large cross-section while P-polarization is maintained at mirrors at which the beam cross-section is smaller.

### Example Embodiment 3

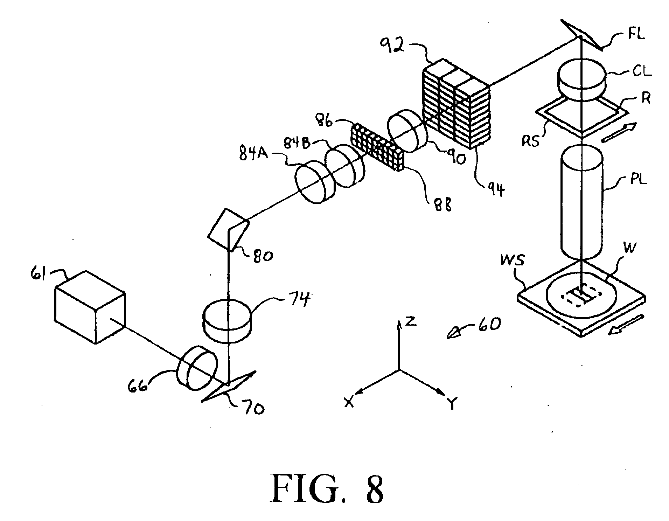

A pattern-transfer apparatus according to Example Embodiment 3 is described with reference to FIG. 8. Components of Example Embodiment 3 that are the same as components of Example Embodiment 2 are designated with the same reference numerals.

An excimer laser 61 emits a laser beam that is polarized substantially parallel to the X-axis. The beam propagates to a half-wave retarder 66 that alters the polarization of the beam so that the beam is substantially polarized along the Z-axis. The beam is then incident to a mirror 70 and is substantially P-polarized with respect to the mirror 70. The mirror 70 reflects the beam to a half-wave retarder 74 and a mirror 80. After reflection by the mirror 70, the beam is substantially polarized parallel to the Y-axis. The half-wave retarder 74 alters the polarization direction of the beam so that the beam is polarized substantially parallel to the X-axis. The mirror 80 then receives the beam as substantially P-polarized light and reflects the beam to a beam expander 84A. The beam expander is generally an afocal optical system and can be a cylindrical optical system. The beam expander 84A expands or otherwise shapes the cross-section of the beam.

The beam is then transmitted by a cylindrical lens 84B and is incident to a fly-eye lens 86 that comprises a plurality of lens elements 88. The lens elements 88 have approximately square cross-sections. After transmission through the fly-eye lens 86, a light flux is formed by portions of the laser beam transmitted by each of the plurality of lens elements 88. A relay lens 90 receives the light flux and directs the light flux to a fly-eye lens 92. The fly-eye lens 92 comprises a plurality of lenses 94, wherein the lenses 94 have a rectangular cross-section. The fly eye-lens 92 redistributes the light flux produced by the fly-eye lens 86. The light flux from the fly-eye lens 92 is then transmitted by an aperture stop (not shown in FIG. 8) and is reflected by a mirror FL to a condenser lens CL and then onto an illumination field of a reticle R.

The light flux transmitted by the reticle R is projected onto a wafer W by a projection optical system PL that images circuit patterns from the reticle R onto the wafer W. The reticle R is held by a stage RS that is movable parallel to the X-axis; the wafer W is held by a stage WS that moves the wafer W in the XY-plane. By illuminating the reticle R while moving the reticle stage RS in the -X direction and moving the wafer stage WS in the +X direction, circuit patterns from the reticle R are projected onto the wafer W.

Because the apparatus of Example Embodiment 8 is constructed so that the laser beam is substantially P-polarized with respect to the mirrors 70, 80, the damage resistance of the mirrors 70, 80 is increased. Thus, the useful lifetime of the projection exposure apparatus is extended.

The projection exposure apparatus of FIG. 8 can be provided with a depolarizer that changes a polarized light flux into an unpolarized light flux. The depolarizer is preferably placed between the mirror 80 and the fly-eye lens 88. One exemplary depolarizer is a birefringent crystal prism that comprises a birefringent wedge bonded to an isotropic wedge. Such a depolarizer is disclosed in U.S. Patent No. 5,253,110, which is incorporated herein by reference.

The pattern-transfer apparatus of Example Embodiment 3 is described as applied to the projection of circuit patterns for the manufacture of semiconductor devices or liquid crystal displays, but it also can serve as an illumination system for a laser fabrication apparatus as disclosed in Japanese unexamined patent document 9-206974.

Example Embodiments 1-3 can use various light sources, including KrF, ArF, XeCl, and F₂ lasers that emit laser pulses at wavelengths of 248 nm, 193 nm, 308 nm, and 156 nm, respectively. The mirrors of the example embodiments receive substantially P-polarized laser beams or light fluxes, but increased damage resistance is also obtained by adjusting the polarization to reduce the magnitude of the S-component. Light fluxes that are partially P-polarized provide increased damage resistance in comparison with S-polarized light fluxes. Elliptical polarizations (including circular polarization) are suitable as well as linear polarizations that are not parallel to the plane of incidence of the flux to the mirrors.

If an illumination system has a plurality of mirrors, it is generally sufficient to use substantially or partially P-polarized light fluxes at only those mirrors at which the light fluxes have high fluences or peak intensities, typically fluences of 100 mJ/cm² or peak intensities of 10⁷ W/cm²/sec or higher,

The half-wave retarders of the foregoing example embodiments are preferably made of birefringent materials such as quartz, but other types of retarders can be used. Representative devices include the Fresnel rhomb and the Mooney rhomb that are discussed in, for example, Eugene Hecht, Optics 304 (2d ed. 1987).

In Example Embodiments 1-3, other methods for improving the damage resistance of the mirrors can be applied. For example, damage-resistant mirror coatings can be used in the optical systems. By combining damage-resistant mirrors with the polarization orientations of the example embodiments, the life and durability of the mirrors are greatly increased.

The foregoing example embodiments use half-wave retarders to orient the polarization direction of incident laser beams to be substantially P-polarized. It will be apparent to those skilled in the art that. retarders having a non-zero retardation can re-orient the polarization direction of a laser beam so that it becomes more P-polarized. Such retarders therefore can be used to improve the damage resistance of coatings.

While it is preferable that the light fluxes be substantially P-polarized with respect to a reflective coating, a significantly P-polarized and partially P-polarized light fluxes also reduce rate at which the coatings damage.

While peak intensity as used herein is fluence divided by pulse duration, it will be apparent that this is an approximation to the actual laser pulse peak intensity that depends on the laser pulse power as a function of time.

Having illustrated and demonstrated the principles of the invention in example embodiments, it should be apparent to those skilled in the art that the example embodiments can be modified in arrangement and detail without departing from such principles. We claim as the invention all that comes within the scope of these claims.

The features disclosed in the foregoing description in the following claims and/or in the accompanying drawings may, both separately and in combination thereof, be material for realising the invention in diverse forms thereof.

## Claims

1. An illumination apparatus for directing a polarized light flux from a light source to a target, comprising:
a first mirror situated so as to receive and reflect the light flux, the first mirror comprising a substrate and a reflective coating, and wherein the light flux is partially P-polarized with respect to the first mirror;
a second mirror situated so as to receive the light flux from the first mirror and reflect the light flux to the target, the second mirror comprising a substrate and a reflective coating; and
a first retarder situated so as to receive the light flux from the first mirror, transmit the light flux to the second mirror, and change the polarization of the light flux so that the light flux is partially P-polarized with respect to the second mirror.

2. The illumination apparatus of claim 1, wherein the first retarder changes the polarization of the light flux so that the light flux is significantly P-polarized with respect to the second mirror.

3. The illumination apparatus of claim 1, wherein the first retarder changes the polarization of the light flux so that the light flux is substantially P-polarized with respect to the second mirror.

4. The illumination apparatus of claim 1, wherein the fluence of the light flux is at least 100 mJ/cm² or the peak intensity of the light flux is at least 10⁷ W/cm².

5. The illumination apparatus of claim 4, further comprising a second retarder placed between the light source and the first mirror, the second retarder changing the polarization of the light flux so that the light flux is significantly P-polarized with respect to the first mirror.

6. The illumination apparatus of claim 4, further comprising a second retarder placed between the light source and the first mirror, the second retarder changing the polarization of the light flux so that the light flux is substantially P-polarized with respect to the first mirror.

7. The illumination apparatus of claim 6, wherein the fluence of the light flux on the first and second mirrors is at least 100 mJ/cm² or the peak intensity on the first and second mirrors is at least 10⁷ W/cm².

8. The illumination apparatus of claim 1, further comprising a second retarder placed between the light source and the first mirror, the second retarder changing the polarization of the light flux so that the light flux is significantly P-polarized with respect to the first mirror.

9. An illumination apparatus for directing a polarized light flux from a light source to a target, comprising:
a first mirror situated so as to receive and reflect the light flux, the first mirror comprising a substrate and a reflective coating and defining a plane of incidence, the plane of incidence containing a line perpendicular to the first mirror and a line parallel to a direction of incidence of the light flux to the first mirror and wherein the light flux is partially P-polarized with respect to the first mirror;
a second mirror situated so as to receive the light flux after reflection by the first mirror and reflect the light flux to the target, the second mirror comprising a substrate and a reflective coating, wherein the light flux is reflected in a plane tilted with respect to the plane of incidence of the first mirror; and
a first retarder placed between the first and second mirrors that changes the polarization of the light flux so that the light flux is partially P-polarized with respect to the second mirror.

10. The illumination apparatus of claim 9, wherein the light flux is substantially P-polarized with respect to the first and second mirrors.

11. The illumination apparatus of claim 9, wherein the retarder is a half-wave retarder.

12. The illumination apparatus of claim 9, wherein the fluence of the light flux is at least 100 mJ/cm² or the peak intensity of the light flux is at least 10⁷ W/cm².

13. The illumination apparatus of claim 9, wherein the second mirror reflects the light flux in a plane that is significantly tilted with respect to the plane of incidence of the first mirror.

14. The illumination apparatus of claim 9, wherein the second mirror reflects the light flux in a plane that is substantially tilted with respect to the plane of incidence of the first mirror.

15. The illumination apparatus of claim 9, further comprising a second retarder placed between the light source and the first mirror, wherein the second retarder changes the polarization direction of the light flux so that the light flux is significantly P-polarized with respect to the first mirror.

16. The illumination apparatus of claim 15, wherein the second retarder is a half-wave retarder.

17. The illumination apparatus of claim 9, wherein the fluence of the light flux on the first and second mirrors is at least 100 mJ/cm² or the peak intensity of the light flux on the first and second mirrors is at least 10⁷ W/cm².

18. The illumination apparatus of claim 9, further comprising a second retarder placed between the light source and the first mirror, the second retarder changing the polarization direction of the light flux so that the light flux is substantially P-polarized with respect to the first mirror.

19. An illumination apparatus for directing a laser beam to a target, comprising:
a laser that emits a polarized laser beam;
a plurality of mirrors situated so as to reflect the laser beam;
a plurality of retarders corresponding to the plurality of mirrors, the retarders being placed so that the laser beam is transmitted by a retarder before reaching a corresponding mirror and changing the direction of polarization of the laser beam so that the laser beam is partially P-polarized with respect to the mirrors; and
an optical integrator situated so as to receive the laser beam from the plurality of mirrors and direct the laser beam to the target.

20. The illumination apparatus of claim 19, wherein the retarders change the polarization of the laser beam so that the laser beam incident to the mirrors is substantially P-polarized with respect to the mirrors.

21. The illumination apparatus of claim 20, wherein the fluence of the laser beam on the plurality of mirrors is at least 100 mJ/cm² or the peak intensity of the laser beam on the plurality of mirrors is at least 10⁷ W/cm².

22. A pattern-transfer apparatus for projecting patterns from a reticle onto a sensitized substrate, comprising:
a reticle stage for holding the reticle;
a substrate stage for holding the sensitized substrate;
a light source that produces a polarized light flux;
an illumination apparatus according to claim 9, situated to receive the light flux and direct the light flux to the reticle, illuminating a portion of the reticle; and
a projection system situated so as to projects the illuminated portion of the reticle onto the sensitized substrate.

23. The pattern transfer apparatus of claim 22, wherein the fluence of the polarized light flux is at least 100 mJ/cm² or the peak intensity is at least 10⁷ W/cm².

24. A method of projecting patterns from a reticle onto a substrate, comprising;
providing a polarized light flux;
reflecting the light flux with a plurality of mirrors;
altering the polarization direction of the light flux so that light flux is substantially P-polarized with respect to the mirrors;
illuminating a portion of the reticle with the light flux; and
projecting an image of the illuminated portion of the-reticle onto the substrate.

25. A method for decreasing the rate at which a mirror is damaged by a light flux, comprising:
providing a retarder;
changing the polarization of the light flux with the retarder so that the light flux is substantially P-polarized with respect to the mirror.

26. An illumination apparatus, comprising:
a light source that produces a polarized light flux that is substantially polarized with respect to an axis;
a first half-wave retarder, situated so as to change the polarization of the light flux to be substantially polarized perpendicular to the axis;
a first mirror situated so as to receive the light flux from the first half-wave retarder and reflect the light flux in a direction perpendicular to the axis, wherein the light flux is substantially P-polarized with respect to the first mirror, the first mirror comprising a substrate and a reflective coating;
a second half-wave retarder situated so as to receive the light flux from the first mirror and change the polarization of the light flux to be substantially parallel to the axis;
a second mirror situated so as to receive the light flux from the second half-wave retarder and reflect the light flux in a direction parallel to the axis, wherein the light flux is P-polarized with respect to the second mirror, the second mirror comprising a substrate and a reflective coating;
a beam expander situated so as to receive the light flux from the second mirror;
a first fly-eye lens situated so as to receive the light flux from the beam expander;
a depolarizer, placed between the second mirror and the first fly-eye lens;
a relay lens situated so as to receive the light flux from the first fly-eye lens;
a second fly-eye lens situated so as to receive the light flux from the relay lens; and
a condenser lens situated so as to direct the light flux to a target, wherein each of the first and the second mirrors has alternating layers of high-index and low-index materials, the high-index layers containing at least one of the materials HfO₂, Al₂O₃, LaF₃, or NdF₃; and the low-index layers containing at least one of the materials SiO₂, MgF₂, AlF₃, or NdAlF₆.
